(19) **Europäisches Patentamt / European Patent Office / Office européen des brevets**

(11) **EP 3 909 065 B1**

(12) # EUROPEAN PATENT SPECIFICATION

(45) Date of publication and mention of the grant of the patent:
**14.06.2023 Bulletin 2023/24**

(21) Application number: **20700853.3**

(22) Date of filing: **10.01.2020**

(51) International Patent Classification (IPC):
**H01J 37/244** (2006.01)  **H01J 37/26** (2006.01)

(52) Cooperative Patent Classification (CPC):
**H01J 37/263; H01J 37/244;** H01J 2237/24514;
H01J 2237/24557; H01J 2237/2614

(86) International application number:
**PCT/IB2020/050168**

(87) International publication number:
**WO 2020/144630 (16.07.2020 Gazette 2020/29)**

(54) **A DEVICE FOR TRANSFORMING A CHARGED PARTICLE BEAM BETWEEN A VORTEX BEAM CONDITION AND A PLANE WAVE BEAM CONDITION**

VORRICHTUNG ZUR UMWANDLUNG EINES STRAHLS GELADENER TEILCHEN ZWISCHEN EINEM WIRBELSTRAHLZUSTAND UND EINEM EBENE-WELLE-STRAHLZUSTAND

DISPOSITIF DE TRANSFORMATION D'UN FAISCEAU DE PARTICULES CHARGÉES ENTRE UNE CONDITION DE FAISCEAU DE VORTEX ET UNE CONDITION DE FAISCEAU D'ONDE PLANE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.01.2019 IT 201900000505**

(43) Date of publication of application:
**17.11.2021 Bulletin 2021/46**

(73) Proprietors:
• **Consiglio Nazionale Delle Ricerche**
  **00185 Roma (IT)**
• **Forschungszentrum Jülich GmbH**
  **52425 Jülich (DE)**
• **University Of Ottawa**
  **Ottawa, Ontario K1N 6N5 (CA)**

(72) Inventors:
• **GRILLO, Vincenzo**
  **41125 Modena (IT)**
• **POZZI, Giulio**
  **40126 Bologna (IT)**
• **DUNIN-BORKOWSKI, Rafal E.**
  **52428 Jülich (DE)**
• **KARIMI, Ebrahim**
  **Ottawa, Ontario K1N 6N5 (CA)**
• **TAVABI, Amir H.**
  **52070 Aachen (DE)**

(74) Representative: **Vanzini, Christian et al**
  **Jacobacci & Partners S.p.A.**
  **Corso Emilia 8**
  **10152 Torino (IT)**

(56) References cited:
**WO-A1-2016/015739**  **WO-A1-2018/046079**
**US-B2- 9 960 008**

• **VINCENZO GRILLO ET AL: "Measuring the orbital angular momentum spectrum of an electron beam", NATURE COMMUNICATIONS, vol. 8, no. 1, 24 May 2017 (2017-05-24), XP055618152, DOI: 10.1038/ncomms15536 cited in the application**
• **VINCENZO GRILLO ET AL: "Measuring the orbital angular momentum spectrum of an electron beam - Supplementary Information", NATURE COMMUNICATIONS, vol. 8, no. 1, 24 May 2017 (2017-05-24), XP055619364, DOI: 10.1038/ncomms15536**
• **HUGO LAROCQUE ET AL: "Nondestructive Measurement of Orbital Angular Momentum for an Electron Beam", ARXIV.ORG, CORNELL UNIVERSITY LIBRARY, 201 OLIN LIBRARY CORNELL UNIVERSITY ITHACA, NY 14853, 12 January 2017 (2017-01-12), XP080741017, DOI: 10.1103/PHYSREVLETT.117.154801**

- HUGO LAROCQUE ET AL: "'Twisted' electrons", CONTEMPORARY PHYSICS., vol. 59, no. 2, 7 February 2018 (2018-02-07), pages 126-144, XP055619655, GB ISSN: 0010-7514, DOI: 10.1080/00107514.2017.1418046
- FAZZINI P F ET AL: "Electron optical phase-shifts by Fourier methods: Analytical versus numerical calculations", ULTRAMICROSCOPY, ELSEVIER, AMSTERDAM, NL, vol. 104, no. 3-4, 1 October 2005 (2005-10-01), pages 193-205, XP027655272, ISSN: 0304-3991 [retrieved on 2005-10-01] cited in the application

**Description**

The research leading to these results has received funding from the European Union's Horizon 2020 research and innovation programme under project/grant agreement Q-SORT No. 766970.

The present invention relates in general to devices and methods for manipulating and measuring orbital angular momentum of particles.

The Orbital Angular Momentum (hereinafter, also OAM) is an important quantity in quantum physics. It is as fundamental as linear momentum. For a paraxial beam (either light or matter waves) the most important component is the one along the average beam propagation direction and differently from linear momentum it is characterized by a discrete spectrum [1].

There are many quantum methods to measure the angular momentum of a particle. Typically diffractive elements of different kind are used to measure each OAM component separately [2, 3], for example by summing and subtracting quanta of OAM and checking the far field propagation of the produced waves.

However these methods are not very quantitative and efficient. The breakthrough in optics has arrived with the introduction of the OAM sorter [4]. In such device, two phase elements introduce a conformal mapping of the wave function from polar to Cartesian coordinates. Thanks to this mapping the OAM is transformed into a linear momentum and can be simply analysed by a lens system.

The overall phase introduced by the two elements can be written as [4]

$$\varphi_1(x,y) = \frac{2\pi a}{\lambda f}\left[y\,\tan^{-1}\left(\frac{y}{x}\right) - x\ln\left(\frac{\sqrt{x^2+y^2}}{b}\right) + x\right] \tag{1a}$$

$$\varphi_2(u,v) = -\frac{2\pi ab}{\lambda f}\left[\exp\left(-\frac{u}{a}\right)\cos\left(\frac{v}{a}\right)\right] \tag{1b}$$

where $a$, $b$ are free parameters, $f$ is the focal length of the Fourier lens between the two phase elements, $x$, $y$ are the Cartesian coordinates in an input plane orthogonal to the beam axis and $u$, $v$ are the Cartesian coordinates in an output plane orthogonal to the beam axis. The Fourier lens transfers onto the output plane the Fourier (or Fraunhofer diffraction) image of the input plane. The parameter $\lambda$ is the wavelength of the beam.

Recently this idea has been transported to electron microscopy [5, 6].

It has been experimentally proved that a set of holograms (i.e. SiN nanofabricated membranes) can introduce the appropriate phase for the conformal mapping. The use of SiN holograms [5] is based on the straight analogy between the phase plates in optics and for the electrons that has been already developed and used in recent research. However SiN holograms entail a strong perturbation of the electron beam and a strong absorption of the electron beam that reduce the efficiency of the device.

McMorran et al [6] have proposed an alternative theoretical solution based on electrostatic phase elements. The first phase element (phase unwrapper) is based on a needle-like electrode and a flat counter-electrode. The second phase element (phase corrector) is based on an array of oppositely charged elongated electrodes forming a periodic array. The electrostatic phase elements produce a phase effect that depends on the electron beam energy. This can become a problem when analysing electrons that have undergone a strong energy loss. These electrons have a different energy and therefore the different electrostatic phase elements have a different alignment or operation.

An aim of the invention is to provide a device for measuring the orbital angular momentum spectrum of a charged particle beam that can overcome at least partially the drawbacks of the above mentioned known devices.

A further aim of the invention is to provide a device for generating vortex beams or their coherent superposition from plane wave beams. This is an application of the reciprocity principle.

In view of the above, there is proposed a device for transforming a charged particle beam between a coherent superposition of helical modes and a coherent superposition of plane wave modes, the device comprising

    a first phase changing element and a second phase changing element arranged along a beam axis at conjugate Fourier planes of a lens system, each of said first and second phase changing elements being configured to introduce a respective phase on the charged particle beam,
    wherein the first phase changing element is a magnetostatic element comprising:

    -    a first conductor configured to be flown by an electric current, said first conductor comprising at least one conductor portion oriented such that flow direction of the electric current has a component parallel to the beam axis, or

- a first permanent magnet having uniform magnetization orthogonal to the beam axis, said first permanent magnet being shaped such that flow direction of an equivalent surface current flowing along a peripheral surface portion of the first permanent magnet has a component parallel to the beam axis; or

wherein the second phase changing element is a magnetostatic element comprising:

- a periodic array of second conductors configured to be flown by respective electric currents in an alternating manner with respect to each other, each second conductor comprising at least one conductor portion oriented such that flow direction of the respective electric current has a component parallel to the beam axis, or
- a periodic array of second permanent magnets with alternating, uniform magnetizations orthogonal to the beam axis, each second permanent magnet being shaped such that flow direction of an equivalent surface current flowing along a peripheral surface portion of the second permanent magnet has a component parallel to the beam axis.

In particular, the first phase changing element can be configured to introduce a phase $\varphi_1(x, y)$ approximately proportional to $\left[ y \tan^{-1}\left(\frac{y}{x}\right) - x \ln\left(\frac{\sqrt{x^2+y^2}}{L1}\right) \right]$ , where $(x, y)$ are Cartesian coordinates orthogonal to the beam axis, and L 1 is the length of the conductor portion of the first conductor or the length of the peripheral surface portion of the first permanent magnet.

Preferably, if currents are used, the first conductor is configured to form a polygonal curve and said at least one conductor portion of the first conductor is inclined to the beam axis.

Alternatively, if permanent magnets are used, the first permanent magnet has a polygonal cross-section and said at least one peripheral surface portion is inclined to the beam axis.

In particular, the second phase changing element can be configured to introduce a phase $\varphi_2(u, v)$ such that

$$\varphi_2(u, v) \propto \sin\left(\frac{2\pi}{L2}u\right) \exp\left(-\frac{2\pi}{L2}v\right);$$

where $(u, v)$ are Cartesian coordinates orthogonal to the beam axis, and $L2$ is the period length of the array of second conductors or array of second permanent magnets.

Preferably, if current are used, each second conductor is configured to form a polygonal curve and said at least one conductor portion of the first conductor is parallel to the beam axis.

Alternatively, if permanent magnets are used, each second permanent magnet has a polygonal cross-section and said at least one peripheral surface portion is parallel to the beam axis.

The device according to the invention can be configured for measuring the orbital angular momentum spectrum of a charged particle beam. In this case, the device comprises, in sequence along the beam axis:

the first phase changing element, which is configured to map azimuthal phase variations associated with an orbital angular momentum of a charged particle into variations over a Cartesian coordinate of a plane orthogonal to the beam axis, and
the second phase changing element, which is configured to provide phase corrections to defects introduced by the first phase changing element.

The device according to the invention employs refractive elements based on magnetic phase effects on the electron beam. The idea is that the phase can be introduced by an appropriate current configuration or by an arrangement of permanent magnets.

With the above mentioned configuration, the phase due to each refractive element is completely achromatic and is non-absorptive (apart from the material supporting the conductors or the permanent magnets), namely it can be used to analyse a single electron at a time (differently from SiN membranes). Furthermore, a current- or magnet-based sorter is less sensible to other conductors and charging than the known electrostatic version.

Embodiments comprising phase changing elements of different kind are comprised in the invention. In particular, a current-based, magnet-based or even electrostatic first phase changing element can be combined with a current-based, magnet-based or electrostatic second phase changing element, provided that at least one of the phase changing elements is current-based or magnet-based.

While the present invention has been conceived, in particular, to overcome some of the limitations of known electron OAM sorters, the skilled person will easily recognize that it can be used potentially in any charged beam based analyser.

Furthermore, the device according to the invention can be configured for generating vortex beams and coherent superpositions of vortex beams from plane wave beams according to the reciprocity principle. In this case the device comprises, in sequence along the beam axis, the second phase changing element and the first phase changing element.

Further characteristics and advantages of the proposed device will be presented in the following detailed description, which refers to the attached drawings, provided purely by way of non-limiting example, in which:

- Figure 1 is a schematic representation of a device according to the invention, when it is used as an OAM measuring or sorting device;
- Figures 2a-f are schematic representations of different embodiments for a first phase changing element of the device of Figure 1;
- Figures 3a-c show geometrical parameters of the embodiments of Figures 2a-f (for the sake of simplicity, current and magnetization signs have been omitted);
- Figures 4a and 4b are schematic perspective and plan view representations of a further embodiment for the first phase changing element;
- Figures 5a-b are schematic representations of different embodiments for a second phase changing element of the device of Figure 1;
- Figure 6 shows geometrical parameters of the embodiments of Figures 5a-b;
- Figure 7 is a schematic representation of a device according to the invention, when it is used as a vortex beam generating device.

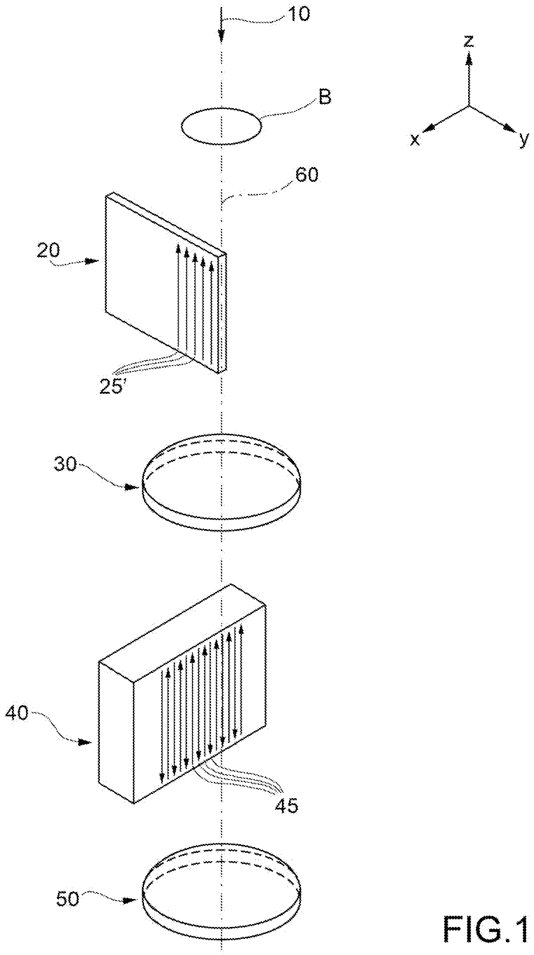

A device for transforming a charged particle beam between a coherent superposition of helical modes and a coherent superposition of plane wave modes is shown schematically in Figure 1.

As intended herein, "superposition of helical modes" means that the charged particle beam carries at least one helical mode, in particular a plurality of superposed helical modes.

As intended herein, "superposition of plane wave modes" means that the charged particle beam carries at least one plane wave mode, in particular a plurality of superposed plane wave modes.

The device of Figure 1 can be used as an OAM measuring device.

A charged particle beam, represented by arrow 10, is incident on the device. The circle B represents the cross-section of the beam. The following description will specifically refer to an electron beam; it is however intended that the invention can be potentially applied to any kind of charged particle. A beam axis representing the average direction of the charged particle beam 10 is designated with 60.

A first phase changing element 20 (hereinafter also indicated as phase unwrapper element) in the input plane of a first Fourier lens system 30 is followed by a second phase changing element 40 (hereinafter indicated as phase corrector element) in the Fourier plane of the first lens system 30. After the phase corrector element 40 there is a second, Fourier-transforming lens system 50. A detecting device such as a CCD camera (not shown) can be positioned at a plane conjugate to the plane of the phase corrector element, to capture the spatially resolved spectrum of the OAM.

As used herein, the terms "first" and "second" have a merely distinctive purpose, and do not necessarily mean that a first item is positioned before a second item relative to the beam propagation direction 60. As a matter of fact, in an embodiment that will be described in the following, the first phase changing element 20 and the second phase changing element 40 are inverted with respect to the beam propagation direction. As will be described in the following, such embodiment defines a vortex beam generator.

Coming back to the embodiment of Figure 1, the above described device is essentially based on unwrapping the azimuthal phase variations associated with an electron's OAM into variations over a Cartesian coordinate of the plane transverse to the electron's propagation 60. This effectively causes the electron's original helical wavefront to become planar and inclined with respect to the beam's original direction of propagation 60. Namely, the degree to which these wavefronts are tilted will increase with the azimuthal variation of the electron's original phase profile, that is, its OAM. As a result, focusing these unwrapped waves with a Fourier lens system 50 will cause electrons originally carrying different OAM values to focus at correspondingly separate lateral positions. By using this method, it is possible to decompose an electron beam's OAM content by measuring the relative electron intensity at each of these possible focusing positions.

The unwrapping process, as detailed in [4], requires the beam's transverse profile in polar coordinates $(r, \varphi)$ to be physically mapped to Cartesian coordinates. Such a transformation can be achieved by means of a conformal mapping between the Cartesian coordinates of the initial beam's profile $(x, y)$ and those of its final profile $(u, v)$. The coordinates $(u, v)$ are log-polar coordinates and can be related to the Cartesian coordinates $(x, y)$ via the transformations

$x = \exp(u)\cos(v)$ and $y = \exp(u)\sin(v)$ or equivalently by $u = \ln\left(\sqrt{x^2 + y^2}\right)$ and $v = \tan^{-1}(y/x)$.

Such mappings are commonly conducted using a set of confocal phase elements performing a log-polar coordinate transformation, such as the electrostatic phase elements disclosed in [6].

According to the invention, a similar refractive approach is adopted to develop a sorter using two phase elements that produce magnetostatic fields acting on the electron beam.

It is well established [7] that in the high energy approximation the phase introduced by an electrostatic and magnetostatic field is given by

$$\varphi(x, y) = \frac{\pi}{\lambda E}\int_z V(x, y, z)dz - \frac{e}{\hbar}\int_z A_z(x, y, z)dz, \qquad (2)$$

where $eE$ is the kinetic energy of the electron, $\lambda$ is the wavelength, $e$ is the absolute value of the electron charge (if equation (3) were generalized to any charged particle, then the charge would be $q$ with the appropriate sign) and $\hbar$ is the reduced Planck constant. $z$ is the main propagation direction of the electron.

The equations for $V$ and $A_Z$ can be reduced to an identical form by noticing that (in Coulomb Gauge)

$$\nabla^2 V = \frac{\rho}{\varepsilon_0} \qquad (3)$$

$$\nabla^2 A_z = \mu_0 j_z \qquad (4)$$

where the charge density $\rho$ play the same role as $j_z$, the component of the current density parallel to the main propagation direction of the electron.

It is to be noticed that in plane components of the current density play no role in the phase. When properly taken into account, these in plane components can produce only small wave translation that can be neglected in most cases.

Finally it is worth noticing that the phase is proportional to the $z$ integral of the potential, therefore a full equation for the phase can be written also as

$$\nabla^2 \varphi = \frac{\pi}{\lambda E}\frac{\sigma}{\varepsilon_0} - \frac{e}{\hbar}\mu_0\zeta \qquad (5)$$

where $\sigma = \int_{-\infty}^{+\infty}\rho dz$ and $\zeta = \int_{-\infty}^{+\infty}j_z dz$.

In fact, due to the high speed of the electron, to a good degree of approximation it can be assumed that what matters is only the $z$ projection of the charge and current.

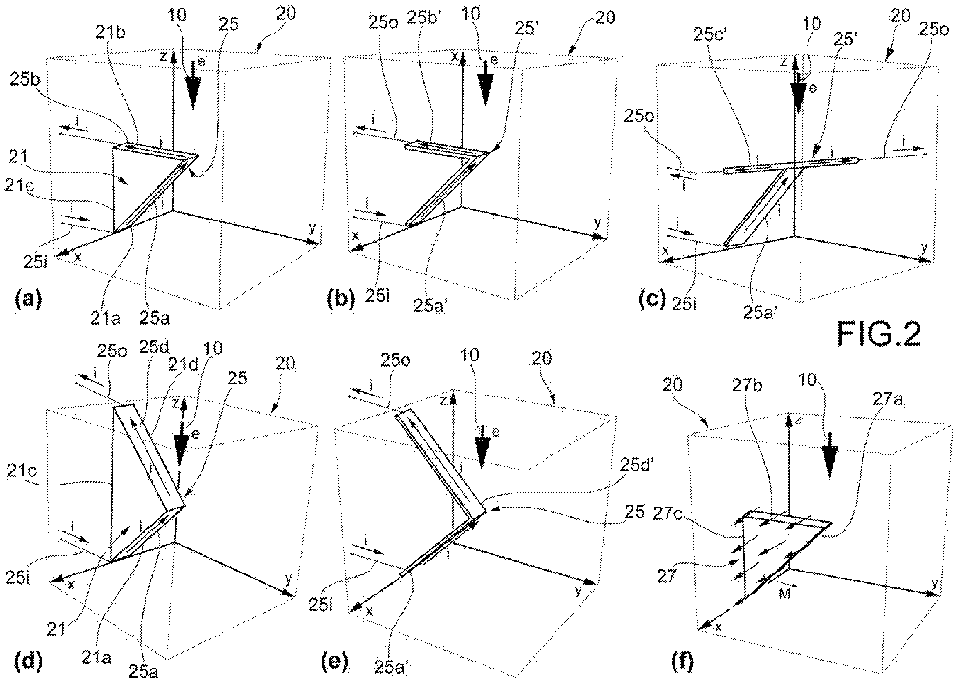

Figures 2a-2f show different embodiments for the phase unwrapper 20. In these figures, corresponding elements have been designated with the same reference numbers.

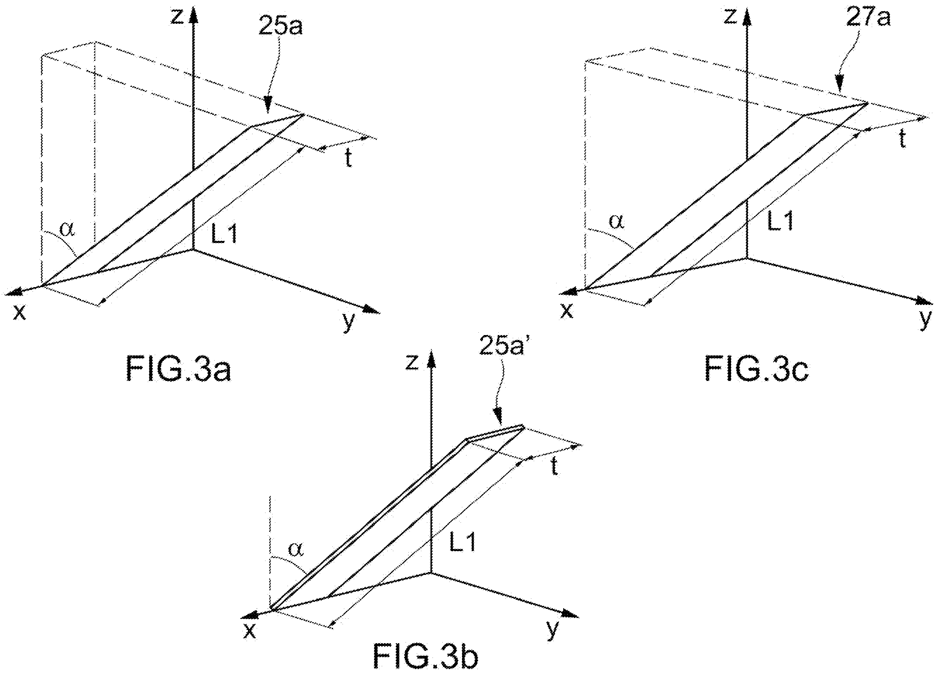

The embodiment of Figure 2a comprises a right-angle triangular support or scaffold 21 arranged in a beam receiving region of the phase unwrapper 20, which is configured to be passed through by the beam 10. The support 21 is carried by a holding structure (not shown). The support 21 has triangle sides 21a, 21b, 21c in the $y$ and $z$ directions and a width $t$ in the $x$ direction (see also Figure 3a). In particular, the support 21 comprises an inclined side 21a inclined with respect to the $z$ direction and a side 21b orthogonal to the $z$ direction, supporting a conductor 25, such as an electrical wire, configured to be flown by an electric current (arrows i in Figure 2a). The conductor 25 comprises an inclined portion 25a carried by the inclined side 21a of the support 21, and a horizontal portion 25b carried by the horizontal side 21b of the support 21. The conductor 25 is connected through lines 25i and 25o to a current generating circuit (not shown) which is located far away from the tip of the structure 21.

The current in the inclined or diagonal conductor portion 25a influences the phase of the electron beam, whereas the one in the horizontal portion 25b has no effect at all.

The best situation is however represented by self-supporting conductors, as there is less material obstructing the beam path and less risk of charging of the scaffold. Figures 2b and 2c show structures where the scaffold has been partially or completely removed (see also Figure 3b).

In particular, Figure 2b shows a self-supporting conductor 25' having the same geometrical arrangement as the conductor of Figure 2a, and comprising an inclined portion 25a' inclined with respect to the z direction and a portion 25b' orthogonal to the z direction.

In the embodiment of Figure 2c, a self-supporting conductor 25' comprises an inclined portion 25a' inclined with respect to the z direction and having an upper end attached to a portion 25c' orthogonal to the z direction and spanning the entire beam receiving region. This guarantees a larger stability than the embodiment of Figure 2b, without need of the scaffold. The price to pay is an additional obstruction of the path.

The embodiment of Figure 2d comprises a triangular support or scaffold 21 arranged in a beam receiving region of the phase unwrapper 20, which is configured to be passed through by the beam 10. The support 21 is carried by a holding structure (not shown). The support is needle-shaped when viewed in plan view, in order to obstruct as less as possible the beam. The support 21 has triangle sides 21a, 21d, 21c in the y and z directions and a width t in the x direction. In particular, the support 21 comprises two inclined sides 21a and 21d inclined with respect to the z direction and supporting a conductor 25. The conductor 25 comprises a first inclined portion 25a carried by the lower inclined side 21a of the support 21, and a second inclined portion 25b carried by the upper inclined side 21d of the support 21.

Figure 2e shows a self-supporting conductor 25' having the same geometrical arrangement as the conductor of Figure 2d, and comprising two inclined portions 25a' and 25d' inclined with respect to the z direction.

Figure 2f show a further embodiment in which a uniformly magnetized permanent magnet 27 is used in place of a current-carrying conductor, having the same shape as the scaffold of the embodiment of Figure 2a. Therefore, the magnet 27 has triangle sides 27a, 27b, 27c in the y and z directions and a width t in the x direction (see also Figure 3c). The arrows in Figure 2d represent the magnetization field $\overline{M}$ of the magnet 27. The magnetization is orthogonal to the beam axis. The shape of the permanent magnet 27 is such that an equivalent surface current flows along an inclined peripheral surface portion 27a of the permanent magnet 27.

In the embodiments of Figures 2a-2c, the $j_z$ component of the current along the tilted portions of the conductor 25 introduces on the beam moving along the z axis a phase $\varphi_1$ equivalent to that of the above described known phase unwrapper with phase $\varphi_1$ (eq. (1a)), apart from a linear and an astigmatic term which can be compensated by deflecting and correcting elements, such as stigmators in an electron microscope:

$$\varphi_1 \approx \frac{e}{\hbar} \frac{\mu_0}{4\pi} i \tan(\alpha) \left[ y \tan^{-1} \left( \frac{y}{x} \right) - x \ln \left( \frac{\sqrt{x^2+y^2}}{L1} \right) \right] \tag{6}$$

where i is the current flowing in the conductor 25, S is the conductor section (for example $t \times s$ where s is the thickness of the conductor), L1 is the length of the inclined portion of the conductor, $\alpha$ is the angle between the inclined current and the electron propagation direction.

In the embodiments of Figures 2d and 2e, the phase introduced by the conductor is given by the sum of two terms respectively associated with the two inclined portions of the conductor.

An equivalent design is obtained using the uniformly magnetized triangular permanent magnet of Figure 2f:

$$\varphi_1 \approx \frac{e}{\hbar} \frac{\mu_0}{4\pi} Mt \left[ y \tan^{-1} \left( \frac{y}{x} \right) - x \ln \left( \frac{\sqrt{x^2+y^2}}{L1} \right) \right] \tag{7}$$

where M is the magnetization field, t is the thickness of the permanent magnet 27 in the x direction, and L1 is the length of the inclined side (or inclined peripheral surface portion) 27a of the magnet 27.

If the magnet were shaped as the scaffold of Figure 2d, the phase introduced by the magnet would be given by the sum of two terms respectively associated with the two inclined portions of the magnet.

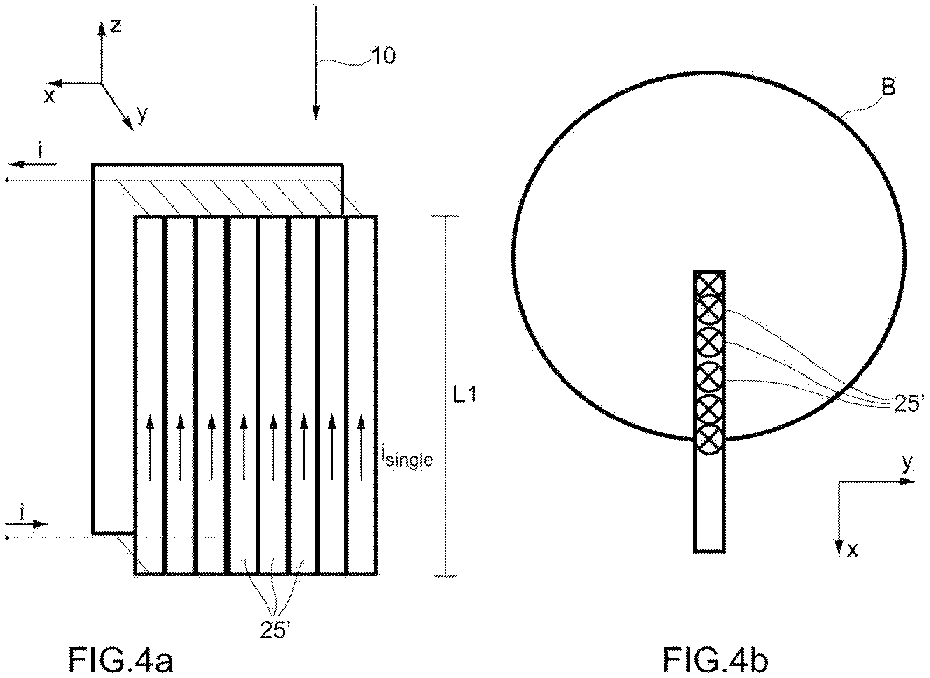

A further embodiment for the phase unwrapper is shown in Figures 4a and 4b. This embodiment comprises a set of N conductors 25' arranged parallel to the beam propagation direction 10, uniformly distributed and closely spaced in a line. Each conductor 25' is flown by a current $i_{single}$ which is uniform for all conductors 25'. The assembly of conductors 25' forms a structure which is needle-shaped when viewed in plan view (Figure 4b), in order to obstruct as less as possible the beam, represented by the circle B in Figure 4b.

The phase, still including unessential linear and astigmatic phase terms, is given by

$$\varphi_1 \approx \frac{e}{\hbar} \frac{\mu_0}{4\pi} i_{single} N \left[ y \tan^{-1} \left( \frac{y}{x} \right) - x \ln \left( \frac{\sqrt{x^2+y^2}}{L1} \right) \right] \tag{8}$$

According to a variant, the embodiment of Figures 4a and 4b may comprise a continuous current sheet instead of a set of discrete currents.

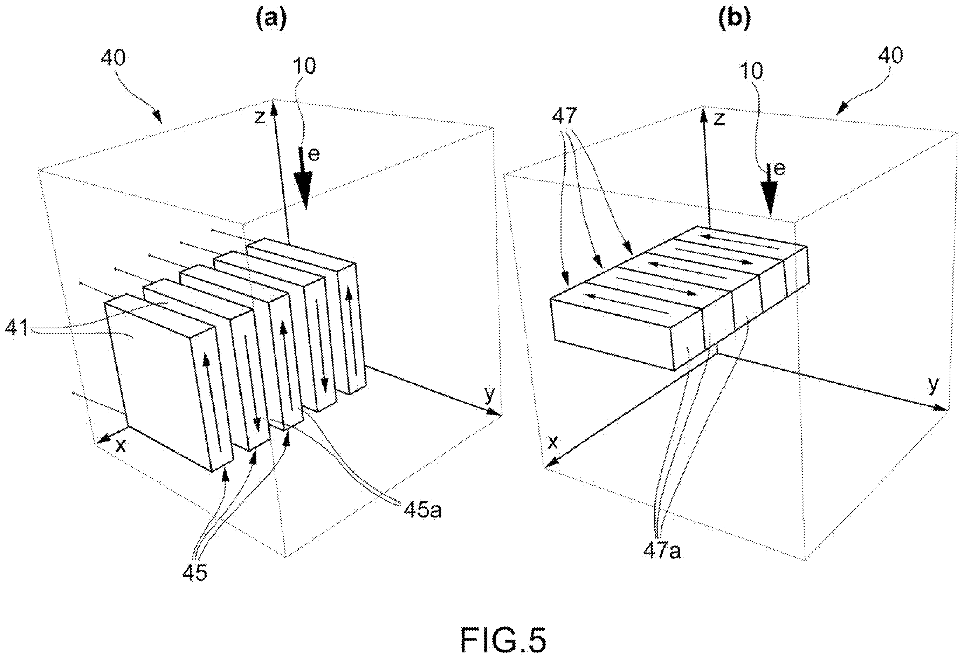

Figures 5a and 5b show different embodiments for the phase corrector 40. For this phase element any periodic in plane current distribution facing to the vacuum can be used.

In fact a periodic boundary condition in one direction and the condition that the phase is an harmonic function $\overline{\nabla}\perp\phi = 0$ force automatically to a solution as in the equation 1b.

The most efficient configuration is shown in Figure 5a. It comprises an array of rectangular supporting elements 41 supporting respective conductors 45 connected to external current generating circuits (not shown). In particular, each conductor 45 comprises a portion 45a parallel to the $z$ axis, i.e. the propagation direction of the beam 10. These conductor portions 45a are recessed in the $y$ direction with respect to the beam axis, in order to intercept only the periphery of the beam cross-section; in this way, only fringing field interacts with the beam. The conductors 45 are flown by an array of currents $i$ along $z$ with alternate signs, with periodicity along an axis orthogonal to the $z$ axis (i.e. the $x$ axis in Figure 5a). This produces a periodic potential in the $x$ repetition direction and an exponential decay of the phase along $y$:

$$\varphi_2(u, v) = \frac{e\mu_0}{\hbar} iT \sin\left(\frac{2\pi}{L2}u\right)\exp\left(-\frac{2\pi}{L2}v\right). \tag{9}$$

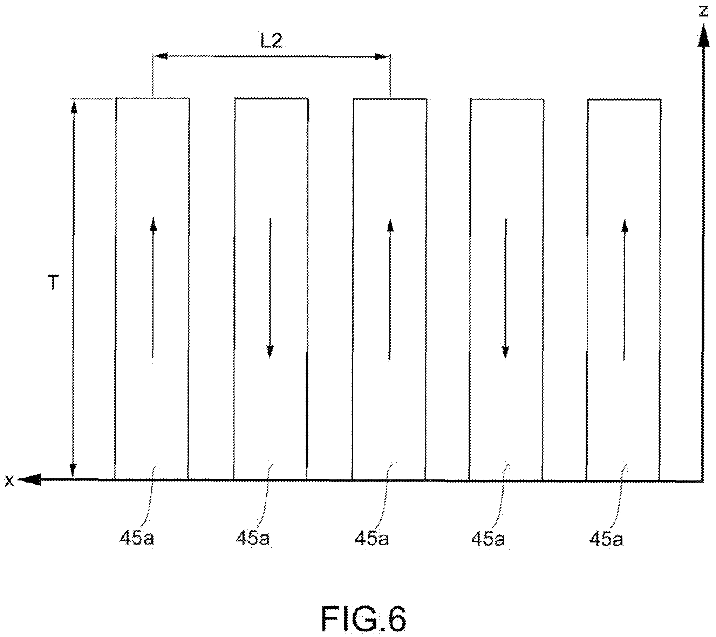

Here $T$ is the thickness along z of the elements 41 (see Figure 6), and $L2$ is the period length of the array. Once again the same effect could be obtained by alternated magnetization.

Any alternating magnetization with vertical equivalent current produces the desired effect. Alternating domains as in Figure 5b are an example of this kind, where the arrows indicate the magnetization field in each domain 47. Each magnet 47 comprises a peripheral surface portion 47a parallel to the beam axis. It must be noted that this result holds also when the thickness of the elements 41 is negligible and the configuration is not the equivalent of that in Figure 5a, b. An explicit solution for this kind of configuration is described in [8] whereas the use in sorting devices was not foreseen.

In general, the electric and magnetic phase elements present an advantage with respect to the holographic approach in that no material and therefore no absorption of electron is necessary with a huge advantage in terms of efficiency. When the two elements are cascaded together the advantage of more than one order of magnitude in efficiency is obtained. Since the efficiency is close to 100% a single electron experiment could be devised.

Another advantage with respect to holograms is the possibility for the real current driven version, to tune the properties of the sorter elements.

The difference between the magnetic and electric sorter is more subtle. In general, magnetic lenses are always preferred in modern microscopes as they are less prone to charging and effects of neighbouring conductors. Moreover the boundary conditions are more easily carried on with magnetic elements, in facts non-magnetic aperture and refractive elements can be inserted without altering the phase.

Moreover the phase introduced by the magnetic elements is independent of energy, making its application easier and a use possible even with ultrarelativistic particles in a wider range of energies.

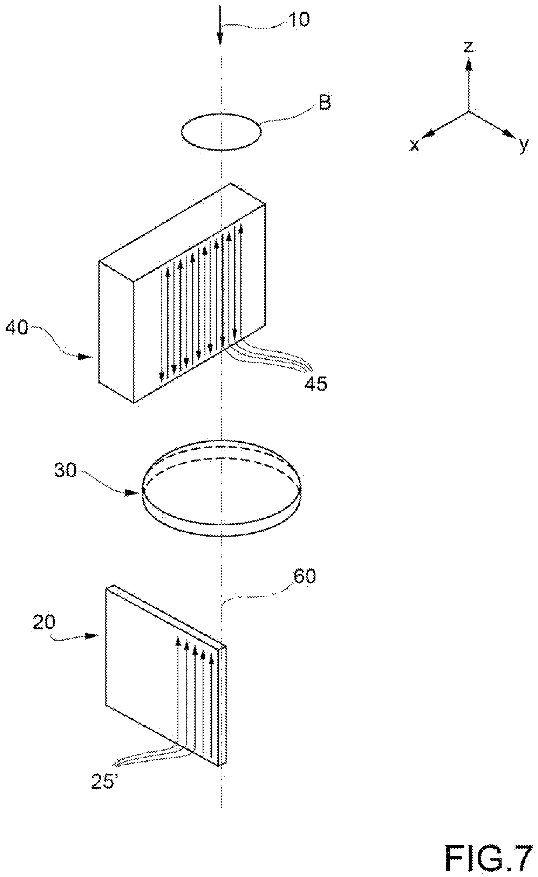

Figure 7 shows a further embodiment of the invention. Elements corresponding to those of Figure 1 have been designated with the same reference numbers.

In this embodiment, the sequence order of the first phase changing element 20 and the second phase changing element 40 has been inverted with respect to Figure 1. This embodiment can be used for generating an output vortex beam, i.e. a beam carrying at least one helical mode, in particular a superposition of helical modes, from an input plane wave beam, i.e. a beam carries at least one plane wave mode, in particular a superposition of plane wave modes.

Bibliographic references

[1] A recent review: K.Y.Bliokh Theory and applications of free-electron vortex states Physics Report 690 (2017) 1-70
[2] K Saitoh et al. Phys Rev Lett 111, 074801 (2013)
[3] G Guzzinati et al. Physical Review A 89, 025803 (2014)
[4] Berkhout GC et al Phys. Rev. Lett. 105, 153601 (2010)
[5] Grillo V et al Nat Comm 8 (2017) 15536
[6] McMorran B et al New Journal of Physics 19 (2017), 023053
[7] H Lichte and M Lehmann Rep. Prog. Phys. 71 (2008) 016102
[8] P.F. Fazzini, G. Pozzi, M. Beleggia Ultramicroscopy 104 (2005) 193-205

**Claims**

1. A device for transforming a charged particle beam (10) between a coherent superposition of helical modes and a coherent superposition of plane wave modes, the device comprising

   a first phase changing element (20) and a second phase changing element (40) arranged along a beam axis (z, 60) at conjugate Fourier planes of a lens system (30), each of said first and second phase changing elements (20, 40) being configured to introduce a respective phase on the charged particle beam (10),
   the device being **characterized in that** the first phase changing element (20) is a magnetostatic element comprising:

   - a first conductor (25; 25') configured to be flown by an electric current, said first conductor comprising at least one conductor portion (25a; 25a'; 25a, 25d) oriented such that flow direction of the electric current has a component parallel to the beam axis (z, 60), or
   - a first permanent magnet (27) having uniform magnetization orthogonal to the beam axis (z, 60), said first permanent magnet (27) being shaped such that flow direction of an equivalent surface current flowing along a peripheral surface portion (27a) of the first permanent magnet (27) has a component parallel to the beam axis (z, 60); or

   **in that** the second phase changing element (40) is a magnetostatic element comprising:

   - a periodic array of second conductors (45) configured to be flown by respective electric currents in an alternating manner with respect to each other, each second conductor of the periodic array of second conductors (45) comprising at least one conductor portion oriented such that flow direction of the respective electric current has a component parallel to the beam axis (z, 60), or
   - a periodic array of second permanent magnets (47) with alternating, uniform magnetizations orthogonal to the beam axis (z, 60), each second permanent magnet of the periodic array of second permanent magnets (47) being shaped such that flow direction of an equivalent surface current flowing along a peripheral surface portion of the second permanent magnet has a component parallel to the beam axis (z, 60).

2. A device according to claim 1, wherein the first phase changing element (20) is configured to introduce a phase $\varphi_1(x,y)$ approximately proportional to

$$\left[ y \tan^{-1}\left(\frac{y}{x}\right) - x \ln\left(\frac{\sqrt{x^2+y^2}}{L1}\right) \right],$$

   where $(x, y)$ are Cartesian coordinates orthogonal to the beam axis (z), and $L1$ is the length of the conductor portion (25a; 25a'; 25a, 25d) of the first conductor (25; 25') or the length of the peripheral surface portion (27a) of the first permanent magnet (27).

3. A device according to claim 1 or 2, wherein the first conductor (25) is configured to form a polygonal curve and said at least one conductor portion (25a; 25a'; 25a, 25d) of the first conductor (25; 25') is inclined to the beam axis (z, 60).

4. A device according to claim 1 or 2, wherein the first permanent magnet (27) has a polygonal cross-section and said at least one peripheral surface portion (27a) is inclined to the beam axis (z, 60).

5. A device according to any of the preceding claims, wherein the second phase changing element (40) is configured to introduce a phase $\varphi_2(u, v)$ such that

$$\varphi_2(u, v) \propto \sin\left(\frac{2\pi}{L2} u\right) \exp\left(-\frac{2\pi}{L2} v\right);$$

   where $(u, v)$ are Cartesian coordinates orthogonal to the beam axis (z, 60), and $L2$ is the period length of the periodic array of second conductors (45) or periodic array of second permanent magnets (47).

6. A device according to claim 1 or 5, wherein each second conductor of the periodic array of second conductors (45) is configured to form a polygonal curve and said at least one conductor portion (45a) of the second conductor (45) is parallel to the beam axis (z, 60).

7. A device according to claim 1 or 5, wherein each second permanent magnet of the periodic array of second permanent magnets (47) has a polygonal cross-section and said at least one peripheral surface portion (47a) is parallel to the beam axis (z, 60).

8. A device according to any of the preceding claims, configured for measuring the orbital angular momentum spectrum of a charged particle beam (10), the device comprising, in sequence along the beam axis (z, 60):

the first phase changing element (20), which is configured to map azimuthal phase variations associated with an orbital angular momentum of a charged particle into variations over a Cartesian coordinate of a plane orthogonal to the beam axis (z, 60), and
the second phase changing element (40), which is configured to provide phase corrections to defects introduced by the first phase changing element (20).

9. A device according to any of claims 1 to 7, configured for generating vortex beams from plane wave beams, the device comprising, in sequence along the beam axis (z, 60), the second phase changing element (40) and the first phase changing element (20).

**Patentansprüche**

1. Vorrichtung zum Transformieren eines geladenen Teilchenstrahls (10) zwischen einer kohärenten Überlagerung von spiralförmigen Moden und einer kohärenten Überlagerung von Ebene-Welle-Moden, mit

einem ersten Phasenänderungselement (20) und einem zweiten Phasenänderungselement (40), die entlang einer Strahlachse (z, 60) bei konjugierten Fourier-Ebenen eines Linsensystems (30) angeordnet sind, wobei jedes von dem ersten und dem zweiten Phasenänderungselement (20, 40) dazu ausgebildet ist, eine jeweilige Phase auf den geladenen Teilchenstrahl (10) aufzubringen,
**gekennzeichnet dadurch, dass** das erste Phasenänderungselement (20) ein magnetostatisches Element ist, das aufweist:

- einen ersten Leiter (25; 25'), der so ausgebildet ist, dass ein elektrischer Strom durch ihn fließt, wobei der erste Leiter mindestens einen Leiterteil (25a; 25a'; 25a, 25d) aufweist, der derart ausgerichtet ist, dass eine Flussrichtung des elektrischen Stroms eine Komponente parallel zu der Strahlachse (z, 60) aufweist, oder
- einen ersten Permanentmagneten (27) mit einer gleichmäßigen Magnetisierung orthogonal zu der Strahlachse (z, 60), wobei der erste Permanentmagnet (27) derart geformt ist, dass eine Flussrichtung eines äquivalenten Oberflächenstroms, der entlang eines Umfangsflächenteils (27a) des ersten Permanentmagneten (27) fließt, eine Komponente parallel zu der Strahlachse (z, 60) aufweist; oder

dadurch, dass das zweite Phasenänderungselement (40) ein magnetostatisches Element ist, das aufweist:

- eine periodische Anordnung von zweiten Leitern (45), die so ausgebildet sind, dass jeweilige elektrische Ströme alternierend in Bezug auf einander durch diese fließen, wobei jeder zweite Leiter der periodischen Anordnung von zweiten Leitern (45) mindestens einen Leiterteil aufweist, der derart ausgerichtet ist, dass eine Flussrichtung des jeweiligen elektrischen Stroms eine Komponente parallel zu der Strahlachse (z, 60) aufweist, oder
- eine periodische Anordnung von zweiten Permanentmagneten (47) mit alternierenden gleichmäßigen Magnetisierungen orthogonal zu der Strahlachse (z, 60), wobei jeder zweite Permanentmagnet der periodischen Anordnung von zweiten Permanentmagneten (47) derart geformt ist, dass eine Flussrichtung eines äquivalenten Oberflächenstroms, der entlang eines Umfangsflächenteils des zweiten Permanentmagneten fließt, eine Komponente parallel zu der Strahlachse (z, 60) aufweist.

2. Vorrichtung nach Anspruch 1, bei der das erste Phasenänderungselement (20) zum Aufbringen einer Phase $\varphi_1(x, y)$ annähernd proportional zu

$$\left[ y \tan^{-1}\left(\frac{y}{x}\right) - x \ln\left(\frac{\sqrt{x^2+y^2}}{L1}\right) \right]$$

ausgebildet ist, wobei (x,y) kartesische Koordinaten orthogonal zu der Strahlachse (z) sind und $L1$ die Länge des Leiterteils (25a; 25a'; 25a, 25d) des ersten Leiters (25; 25') oder die Länge des Umfangsflächenteils (27a) des ersten Permanentmagneten (27) ist.

3. Vorrichtung nach Anspruch 1 oder 2, bei der der erste Leiter (25) zum Bilden einer Polygonkurve ausgebildet ist und der mindestens eine Leiterteil (25a; 25a'; 25a, 25d) des ersten Leiters (25; 25') in Bezug auf die Strahlachse (z, 60) geneigt ist.

4. Vorrichtung nach Anspruch 1 oder 2, bei der der erste Permanentmagnet (27) einen Polygonquerschnitt aufweist und der mindestens eine Umfangsflächenteil (27a) in Bezug auf die Strahlachse (z, 60) geneigt ist.

5. Vorrichtung nach einem der vorhergehenden Ansprüche, bei der das zweite Phasenänderungselement (40) zum Aufbringen einer Phase $\varphi_2(u,v)$ derart, dass

$$\varphi_2(u, v) \propto \sin\left(\frac{2\pi}{L2}u\right) \exp\left(-\frac{2\pi}{L2}v\right)$$

gilt, ausgebildet ist; wobei $(u,v)$ kartesische Koordinaten orthogonal zu der Strahlachse (z, 60) sind und L2 die Periodenlänge der periodischen Anordnung von zweiten Leitern (45) oder der periodischen Anordnung von zweiten Permanentmagneten (47) ist.

6. Vorrichtung nach Anspruch 1 oder 5, bei der jeder zweite Leiter der periodischen Anordnung von zweiten Leitern (45) zum Bilden einer Polygonkurve ausgebildet ist und der mindestens eine Leiterteil (45a) des zweiten Leiters (45) parallel zu der Strahlachse (z, 60) ist.

7. Vorrichtung nach Anspruch 1 oder 5, bei der jeder zweite Permanentmagnet der periodischen Anordnung von zweiten Permanentmagneten (47) einen Polygonquerschnitt aufweist und der mindestens eine Umfangsflächenteil (47a) parallel zu der Strahlachse (z, 60) ist.

8. Vorrichtung nach einem der vorhergehenden Ansprüche, ausgebildet zum Messen des Bahndrehimpulsspektrums eines geladenen Teilchenstrahls (10), wobei die Vorrichtung entlang der Strahlachse (z, 60) der Reihe nach Folgendes aufweist:

das erste Phasenänderungselement (20), das zum Abbilden von azimutalen Phasenvariationen in Zusammenhang mit einem Bahndrehimpuls eines geladenen Teilchens auf Variationen über einer kartesischen Koordinate einer Ebene orthogonal zu der Strahlachse (z, 60) ausgebildet ist, und
das zweite Phasenänderungselement (40), das zum Liefern von Phasenkorrekturen von Defekten, die durch das erste Phasenänderungselement (20) hervorgerufen werden, ausgebildet ist.

9. Vorrichtung nach einem der Ansprüche 1 bis 7, ausgebildet zum Erzeugen von Wirbelstrahlen aus Ebene-Welle-Strahlen, wobei die Vorrichtung das zweite Phasenänderungselement (40) und das erste Phasenänderungselement (20) aufweist, die entlang der Strahlachse (z, 60) der Reihe nach angeordnet sind.

**Revendications**

1. Dispositif pour la transformation d'un faisceau de particules chargées (10) entre une superposition cohérente de modes hélicoïdaux et une superposition cohérente de modes à onde plane, le dispositif comprenant

un premier élément de changement de phase (20) et un second élément de changement de phase (40) agencés le long d'un axe de faisceau (z, 60) au niveau de plans de Fourier conjugués d'un système de lentille (30), chacun desdits premier et second éléments de changement de phase (20, 40) étant configuré pour introduire une phase respective sur le faisceau de particules chargées (10),
le dispositif étant **caractérisé en ce que** le premier élément de changement de phase (20) est un élément magnétostatique comprenant :

- un premier conducteur (25 ; 25') configuré pour être parcouru par un courant électrique, ledit premier conducteur comprenant au moins une portion de conducteur (25a ; 25a' ; 25a, 25d) orientée de sorte que la direction de circulation du courant électrique possède une composante parallèle à l'axe de faisceau (z, 60), ou
- un premier aimant permanent (27) ayant une aimantation uniforme orthogonale à l'axe de faisceau (z, 60), ledit premier aimant permanent (27) étant façonné de sorte que la direction de circulation d'un courant de surface équivalent circulant le long d'une surface périphérique (27a) du premier aimant permanent (27) possède une composante parallèle à l'axe de faisceau (z, 60) ; ou

**en ce que** le second élément de changement de phase (40) est un élément magnétostatique comprenant :

- un réseau périodique de seconds conducteurs (45) configurés pour être parcourus par des courants électriques respectifs d'une manière alternée les uns par rapport aux autres, chaque second conducteur du réseau périodique de seconds conducteurs (45) comprenant au moins une portion de conducteur orientée de sorte que la direction de circulation du courant électrique respectif possède une composante parallèle à l'axe de faisceau (z, 60), ou
- un réseau périodique de seconds aimants permanents (47) ayant des aimantations uniformes alternées orthogonales à l'axe de faisceau (z, 60), chaque second aimant permanent du réseau périodique de seconds aimants permanents (47) étant façonné de sorte que la direction de circulation d'un courant de surface équivalent circulant le long d'une portion de surface périphérique du second aimant permanent possède une composante parallèle à l'axe de faisceau (z, 60) .

2. Dispositif selon la revendication 1, dans lequel le premier élément de changement de phase (20) est configuré pour introduire une phase $\varphi_1(x,y)$ approximativement proportionnelle à

$$\left[ y \tan^{-1}\left(\frac{x}{y}\right) - x \ln\left(\frac{\sqrt{x^2+y^2}}{L1}\right) \right],$$

où (x,y) sont des coordonnées cartésiennes orthogonales à l'axe de faisceau (z), et L1 est la longueur de la portion de conducteur (25a ; 25a' ; 25a, 25d) du premier conducteur (25 ; 25') ou la longueur de la portion de surface périphérique (27a) du premier aimant permanent (27).

3. Dispositif selon la revendication 1 ou 2, dans lequel le premier conducteur (25) est configuré pour former une courbe polygonale et ladite au moins une portion de conducteur (25a ; 25a' ; 25a, 25d) du premier conducteur (25 ; 25') est inclinée par rapport à l'axe de faisceau (z, 60).

4. Dispositif selon la revendication 1 ou 2, dans lequel le premier aimant permanent (27) possède une section transversale polygonale et ladite au moins une portion de surface périphérique (27a) est inclinée par rapport à l'axe de faisceau (z, 60).

5. Dispositif selon l'une quelconque des revendications précédentes, dans lequel le second élément de changement de phase (40) est configuré pour introduire une phase $\varphi_2(u,v)$ de sorte que

$$\varphi_2(u, v) \propto \sin\left(\frac{2\pi}{L2}u\right) \exp\left(-\frac{2\pi}{L2}v\right);$$

où (u,v) sont des coordonnées cartésiennes orthogonales à l'axe de faisceau (z, 60), et L2 est la longueur de période du réseau périodique de seconds conducteurs (45) ou du réseau périodique de seconds aimants permanents (47).

6. Dispositif selon la revendication 1 ou 5, dans lequel chaque second conducteur du réseau périodique de seconds conducteurs (45) est configuré pour former une courbe polygonale et ladite au moins une portion de conducteur (45a) du second conducteur (45) est parallèle à l'axe de faisceau (z, 60).

7. Dispositif selon la revendication 1 ou 5, dans lequel chaque second aimant permanent du réseau périodique de seconds aimants permanents (47) possède une section transversale polygonale et ladite au moins une portion de surface périphérique (47a) est parallèle à l'axe de faisceau (z, 60).

8.  Dispositif selon l'une quelconque des revendications précédentes, configuré pour mesurer le spectre de moment angulaire orbital d'un faisceau de particules chargées (10), le dispositif comprenant, en séquence le long de l'axe de faisceau (z, 60) :

    le premier élément de changement de phase (20), qui est configuré pour transposer des variations azimutales de phase associées à un moment angulaire orbital d'une particule chargée en variations sur une coordonnée cartésienne d'un plan orthogonal à l'axe de faisceau (z, 60), et
    le second élément de changement de phase (40), qui est configuré pour fournir des corrections de phase à des défauts introduits par le premier élément de changement de phase (20).

9.  Dispositif selon l'une quelconque des revendications 1 à 7, configuré pour générer des faisceaux à vortex à partir de faisceaux à onde plane, le dispositif comprenant, en séquence le long de l'axe de faisceau (z, 60), le second élément de changement de phase (40) et le premier élément de changement de phase (20).

FIG.1

FIG.2

EP 3 909 065 B1

FIG.3a

FIG.3b

FIG.3c

FIG.4a

FIG.4b

EP 3 909 065 B1

**(a)**

**(b)**

FIG.5

EP 3 909 065 B1

FIG.6

EP 3 909 065 B1

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- A recent review: K.Y.Bliokh Theory and applications of free-electron vortex states. *Physics Report,* 2017, vol. 690, 1-70
- **K SAITOH et al.** *Phys Rev Lett,* 2013, vol. 111, 074801
- **G GUZZINATI et al.** *Physical Review A,* 2014, vol. 89, 025803
- **BERKHOUT GC et al.** *Phys. Rev. Lett.,* 2010, vol. 105, 153601
- **GRILLO V et al.** *Nat Comm,* 2017, vol. 8, 15536
- **MCMORRAN B et al.** *New Journal of Physics,* 2017, vol. 19, 023053
- **H LICHTE ; M LEHMANN.** *Rep. Prog. Phys,* 2008, vol. 71, 016102
- **P.F. FAZZINI ; G. POZZI ; M. BELEGGIA.** *Ultramicroscopy,* 2005, vol. 104, 193-205